# EUROPEAN PATENT APPLICATION

(11) **EP 1 939 940 A2**
(43) Date of publication of application: **02.07.2008**
(21) Application number: 07101698.4
(22) Date of filing: 02.02.2007
(51) Int. Cl.: H01L 27/088

(54) **RF integrated circuit device**

(30) Priority: 27.12.2006 US 616489
(71) Applicant: MediaTek Inc., 1st Science-Based Industrial Park Hsin-Chu 300 (TW)
(72) Inventor: Wang, YuJen, Hsinchu City (TW)
(74) Representative: Kewitz, Ansgar

(57) **Abstract**

A differential pair of an RF integrated circuit device is disclosed. The differential pair of the integrated circuit device includes a first MOS formed by a multiple finger configuration, having a plurality of first gate fingers; a second MOS formed by the multiple fingers configuration, having a plurality of second gate fingers, wherein each two first gate fingers interdigitate with each two second gate fingers.

## Description

### BACKGROUND OF THE INVENTION

### Field of the Invention

The invention relates to an integrated circuit device, and more particularly to a differential pair configuration of an integrated circuit device for reducing layout area and parasitic capacitance.

### Description of the Related Art

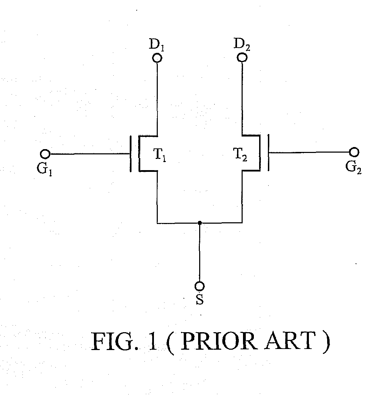

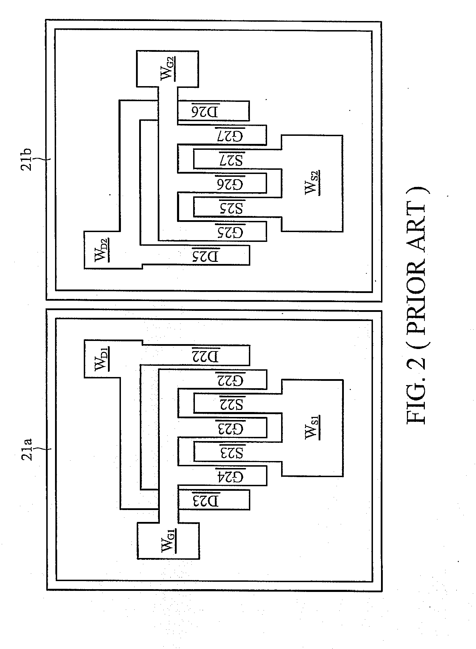

High-frequency integrated circuit devices are widely applied in telecommunications equipment and broadband wireless communications. The high-frequency integrated circuit devices include circuits such as a Gilbert cell. A Gilbert cell typically incorporates a differential amplification circuit and an emitter follower. A typical Gilbert cell features a circuit formed by cross-connecting two differential amplification circuits connected in series to one differential amplification circuit. Fig. 1 is a circuit diagram showing a circuit configuration of a typical differential pair. Two MOS transistors form the differential pair with a common source to multiply the difference between two inputs, G1 and G2, by a predetermined constant, to obtain the differential gain. Fig. 2 further illustrates the layout of the differential pair and shows an example of a conventional circuit layout of the typical differential pair. The transistor T1 includes gate fingers G22 to G24 electrically connected to a gate wire W_{G1}, drain fingers D22 and D23 electrically connected to a drain wire W_{D1}, and source fingers S22 and S23 electrically connected to a source line W_{S1}. The transistor T1 further comprises a guard ring 21a coupled to the body of the transistor T1. The transistor T2 includes gate fingers G25 to G27 electrically connected to a gate wire W_{G2}, drain fingers D25 and D26 electrically connected to a drain wire W_{D2}, and source fingers S25 and S26 electrically connected to a source line W_{S2}. The transistor T2 further comprises a guard ring 21b coupled to the body of the transistor T2. In the conventional layout, the differential pair occupies too much layout area, easily generating large parasitic capacitance due to the metal connection.

### BRIEF SUMMARY OF THE INVENTION

A differential pair configuration of an integrated circuit for reducing layout area and parasitic capacitance is provided.

An exemplary embodiment of an integrated circuit device comprises a first MOS formed by a multiple fingers configuration, having a plurality of first gate fingers; a second MOS formed by the multiple fingers configuration, having a plurality of second gate fingers, wherein each two first gate fingers interdigitate with each two second gate fingers.

Another exemplary embodiment of the integrated circuit device comprises a plurality of first gate fingers; a plurality of second gate fingers, wherein each two first gate fingers interdigitate with each two second gate fingers; a plurality of first drain fingers formed between each two first gate fingers; a plurality of second drain fingers formed between each two second gate fingers; a plurality of common source fingers formed between one first gate finger and one second gate finger.

Another exemplary embodiment of the integrated circuit device comprises a first differential pair and a second differential pair. The first differential pair comprises a first drain finger coupled to a first drain wire, a first gate finger coupled to a first gate wire, a first source finger coupled to a common source wire, a second gate finger coupled to a second gate wire, and a second drain finger coupled to a second drain wire. The second differential pair comprises a third drain finger coupled to the first drain wire, a third gate finger coupled to the first gate wire, a second source finger coupled to the common source wire, a fourth gate finger coupled to the second gate wire, and a fourth drain finger coupled to the second drain wire.

A detailed description is given in the following embodiments with reference to the accompanying drawings.

### BRIEF DESCRIPTION OF THE DRAWINGS

The invention can be more fully understood by reading the subsequent detailed description and examples with references made to the accompanying drawings, wherein:

Fig. 1 is a circuit diagram showing a circuit configuration of a typical differential pair.

Fig. 2 shows an example of a conventional circuit layout of the typical differential pair.

Fig. 3 shows a circuit layout of an embodiment of the differential pair.

Fig. 4 is a cross section view of the differential pair in Fig. 3.

Fig. 5 shows a circuit layout of another embodiment of the differential pair.

### DETAILED DESCRIPTION OF THE INVENTION

The following description is of the best-contemplated mode of carrying out the invention. This description is made for the purpose of illustrating the general principles of the invention and should not be taken in a limiting sense. The scope of the invention is best determined by reference to the appended claims.

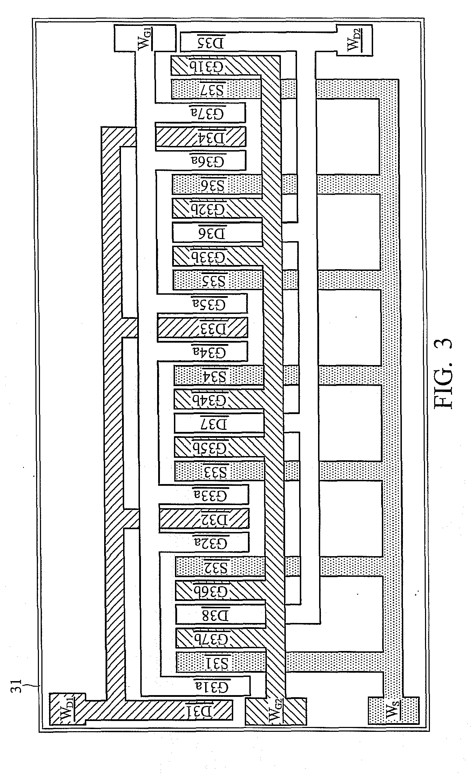

The following describes an embodiment of an integrated circuit device of the invention, with a differential pair given as an example. The differential pair relating of the invention has a circuit configuration as shown in Fig. 1, and is characterized by a circuit layout of the transistors, T1 and T2. Fig. 3 shows a circuit layout of an embodiment of the differential pair. The transistors T1 and T2 both have a multiple finger configuration. The transistor T1 has drain fingers D31 to D34 (D31, D32, D33 and D34) electrically connected to a drain wire W_{D1}, and gate fingers G31a to G37a (G31a, G32a, G33a, G34a, G35a, G36a and G37a) electrically connected to a gate line W_{G1}. The transistor T2 has drain fingers D35 to D38 (D35, D36, D37 and D38) electrically connected to a drain wire W_{D2}, and gate fingers G31b to G37b (G31b, G32b, G33b, G34b, G35b, G36b and G37b) electrically connected to a gate line W_{G2}. The transistors T1 and T2 share source fingers S31 to S37 (S31, S32, S33, S34, S35, S36 and S37) electrically connected to a source line Wₛ. The source line Wₛ can be connected to a virtual ground. The guard ring 31 is coupled to both the bodies of the transistors T1 and T2. In this layout diagram, each two gate fingers of transistor T1 interdigitate with each two gate fingers of transistor T2. The drain fingers D31 to D34 are disposed between two gate fingers of transistor T1. The drain fingers D35 to D38 are disposed between two gate fingers of transistor T2. The source fingers S31 to S37 are disposed between one gate finger of transistor T1 and one gate finger of transistor T2. According to the differential pair configuration shown in Fig. 3, the layout area can be reduced and the source parasitic capacitance also can be reduced due to the shared source and guard ring.

It should be noted that the differential pair circuit of the invention can be utilized in integrated circuit devices operated in high frequency, such as RF devices.

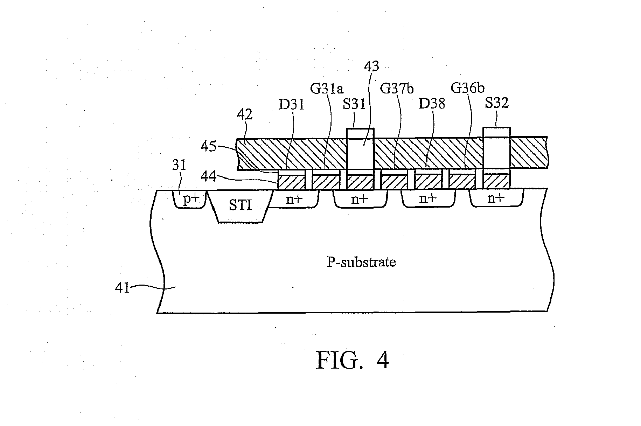

Fig. 4 is a cross sectional view of the differential pair shown in Fig. 3. In Fig. 4, for brevity, only the drain fingers D31 and D32, gate fingers G31a and G37b, and source fingers S31 and S32 are shown, others have similar structure. A p+ region is doped on a P-substrate 41 to form the guard ring 31. The two differential pair configurations are divided by a shallow trench isolation (STI) doped on the P-substrate. A plurality of n+ regions is doped on the P-substrate 41 to form source fingers and drain fingers. The fingers including gate fingers, drain fingers, and source fingers, are formed by a conductive layer, such as conductive layer 44, and a metal contact pad, such as metal contact pad 45. The remaining space, with the exception of the conductive layer and metal contact pad, is filled with isolation material. The metal contact pads of the source fingers are not disposed in the same layer in which metal contact pads of the drain fingers and gate fingers are disposed. When the metal contact pads of the drain fingers and gate fingers are formed, an isolation layer 42 covers the metal contact pads. A plurality of vias, such as via 43, is then formed by perforating the isolation layer 42 based on the position of source fingers and filled with conductive material. The metal contact pads are then formed on the vias. According to the configuration shown in Fig. 4, the source parasitic capacitance can be efficiently reduced and the differential pair obtains better matching of the transistors T1 and T2.

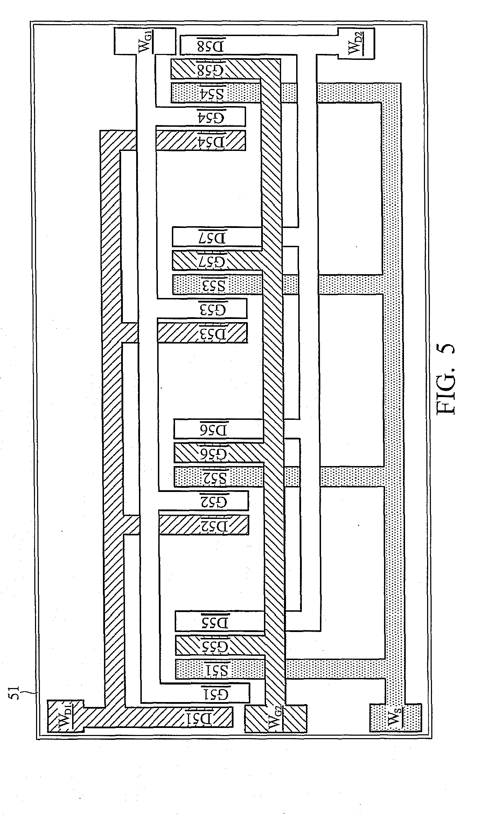

Fig. 5 shows a circuit layout of another embodiment of the differential pair. The transistors T1 and T2 both have a multiple finger configuration. The transistor T1 has drain fingers D51, D52, D53 and D54 electrically connected to a drain wire W_{D1}, and gate fingers G51, G52, G53 and G54 electrically connected to a gate line W_{G1}. The transistor T2 has drain fingers D55, D56, D57 and D58 electrically connected to a drain wire W_{D2}, and gate fingers G55, G56, G57 and G58 electrically connected to a gate line W_{G2}. The transistors T1 and T2 share source fingers S51, S52, S53, and S54 electrically connected to a source line Wₛ. The source line Wₛ can be connected to a virtual ground. In the circuit layout, a guard ring 51 is provided and is coupled to both the bodies of the transistors T1 and T2. In Fig. 5, we can find that the differential pair comprises plural differential pair units, such as the differential pair unit formed by the drain finger D51, the gate finger G51, the source finger S51, the gate finger G55, and the drain finger D55. In this embodiment, the differential pair comprises four differential pair units, and in another embodiment, the differential pair may only comprise one differential pair unit. The advantage of the configuration shown in Fig. 5 is that the source parasitic capacitance can be reduced due to the shared source and guard ring.

While the invention has been described by way of example and in terms of preferred embodiment, it is to be understood that the invention is not limited thereto. To the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. An RF integrated circuit device, comprising:
a first MOS formed by a multiple fingers configuration, having a plurality of first gate fingers; and
a second MOS formed by the multiple fingers configuration, having a plurality of second gate fingers, wherein each two first gate fingers interdigitate with each two second gate fingers.

2. The device as claimed in claim 1, further comprising a plurality of doping regions formed between each two gate fingers.

3. The device as claimed in claim 1, further comprising a plurality of first drain fingers formed between each two first gate fingers.

4. The device as claimed in claim 1, further comprising a plurality of second drain fingers formed between each two second gate fingers.

5. The device as claimed in claim 1, further comprising a plurality of common source fingers formed between one first gate finger and one second gate finger.

6. The device as claimed in claim 1, further comprising a guard ring.

7. An RF integrated circuit device, comprising:
a plurality of first gate fingers;
a plurality of second gate fingers, wherein each two first gate fingers interdigitate with each two second gate fingers;
a plurality of first drain fingers formed between each two first gate fingers;
a plurality of second drain fingers formed between each two second gate fingers; and
a plurality of common source fingers formed between one first gate finger and one second gate finger.

8. The device as claimed in claim 7, further comprising a guard ring.

9. The device as claimed in claim 7, wherein the common source fingers are disposed in a first layer and the first and second drain fingers are disposed in a second layer which is different from the first layer.

10. The device as claimed in claim 7, wherein the common source fingers contact corresponding doping regions through vias.

11. The device as claimed in claim 10, wherein the vias are filled with conductive materials.

12. The device as claimed in claim 7, wherein the common source fingers are isolated from the first and second drain fingers by an isolate layer.

13. An RF integrated circuit device, comprising:
a first differential pair, comprising:
a first drain finger coupled to a first drain wire;
a first gate finger coupled to a first gate wire;
a first source finger coupled to a common source wire;
a second gate finger coupled to a second gate wire; and
a second drain finger coupled to a second drain wire.

14. The device as claimed in claim 13, further comprising:
a second differential pair, comprising:
a third drain finger coupled to the first drain wire;
a third gate finger coupled to the first gate wire;
a second source finger coupled to the common source wire;
a fourth gate finger coupled to the second gate wire; and
a fourth drain finger coupled to the second drain wire.

15. The device as claimed in claim 13, wherein the first differential pair is surrounded by an isolation material.

16. The device as claimed in claim 13, wherein the first source finger is disposed in a first layer and the first and second drain fingers are disposed in a second layer which is different from the first layer.

17. The device as claimed in claim 14, wherein the first source finger contacts a corresponding doping region through a via.

18. The device as claimed in claim 17, wherein the via is filled with conductive materials.
